# EUROPEAN PATENT SPECIFICATION

(11) **EP 1 704 179 B1**
(45) Date of publication and mention of the grant of the patent: **28.12.2011**
(21) Application number: 05705497.5
(22) Date of filing: 11.01.2005
(51) Int. Cl.: C08K 3/00, C08K 3/16, C08L 101/00, H01B 3/30, H01B 3/40, H01L 23/373, C08K 5/00, C08K 9/00

(54) **THERMALLY CONDUCTIVE THERMOPLASTIC RESIN COMPOSITIONS**
THERMISCH LEITFÄHIGE THERMOPLASTHARZZUSAMMENSETZUNGEN
COMPOSITIONS DE RESINE THERMOPLASTIQUE THERMOCONDUCTRICE

(30) Priority: 12.01.2004 US 535929 P
(43) Date of publication of application: 27.09.2006
(73) Proprietor: E.I. DU PONT DE NEMOURS AND COMPANY, Wilmington, DE 19898 (US)
(72) Inventor: KOBAYASHI, Toshikazu, Chadds Ford, PA 19317 (US); FREDRICKSON, Becky, Pearland, TX 77584 (US)
(74) Representative: Heinemann, Monica
(86) International application number: PCT/US2005/000866
(87) International publication number: WO 2005/071001

(56) References cited:
- EP-A- 0 944 098
- US-A- 5 118 207
- PATENT ABSTRACTS OF JAPAN vol. 2003, no. 06, 3 June 2003 (2003-06-03) & JP 2003 040619 A (HITACHI METALS LTD; HMK:KK; HITACHI METALS TRADING CO LTD), 13 February 2003 (2003-02-13) cited in the application

## Description

### Field of the Invention

The present invention relates to thermally conductive thermoplastic resin compositions comprising thermoplastic polymer and calcium fluoride, and, optionally, one or more of fibrous filler, liquid crystalline polymer, and polymeric toughening agent.

### Background of the Invention

Because of their excellent mechanical and electrical insulation properties, thermoplastic polymeric resin compositions are used in a broad range of applications such as in automotive parts, electrical and electronic parts, machine parts and the like. In many cases, because of the design flexibility they permit and their low cost, polymer resin compositions have replaced metal in these applications. However, many of these applications require that the parts be in the vicinity of or in contact with heat sources such as motors or electrical lights. It is therefore desirable to form these parts from materials that are sufficiently thermally conductive to dissipate the heat generated. While metal parts thermally conductive, they are also often electrically conductive, which can be undesirable in certain applications. Thermoplastic resin compositions are generally thermally insulating and typically electrically insulating unless they contain large amounts of electrically conductive additives. Thus, a thermally conductive, electrically insulating thermoplastic resin composition would be desirable and could replace metals, and in particular, aluminum, in many applications.

Japanese patent application publication 2003-040619 discloses a method of surface treating calcium fluoride powder with a silane coupling agent and blending the coated powder with thermoplastic resins and, optionally, fillers to produce a thermally conductive composition However, the surface treatment step adds additional complexity and expense.

### Summary of the Invention

Disclosed and claimed herein are thermally conductive thermoplastic polymer compositions, comprising:
(a) 15 to 70 weight percent of at least one isotropic thermoplastic polymer selected from the group consisting of thermoplastic polyesters, polyamides, polyacetals, polycarbonates, polyphenylene oxides, polyphenylene sulfides, polysulphones, polyarylates, polyetheretherketones, polyetherketoneketones, and syndiotactic polystyrenes;
(b) 30 to 70 weight percent of uncoated surface coated or treated calcium fluoride;
(c) 0 to 30 weight percent of at least one fibrous filler;
(d) 5 to 40 weight percent of at least one liquid crystalline polymer and;
(e) 0 to 15 weight percent of at least one polymeric toughening agent, the above stated percentages being based on the total weight of the composition.

Further disclosed and claimed herein are thermally conductive thermoplastic polymer compositions as described above wherein said calcium fluorine is

### Detailed Description of the Invention

The composition of the present invention comprises (a) at least one isotropic thermoplastic polymer, (b) calcium fluoride, optionally (c) at least one fibrous filler, (d) at least one liquid crystalline polymer, optionally (e) at least one polymeric toughening agent, and optionally (f) additional additives.

By "thermoplastic polymer" herein is meant an isotropic thermoplastic polymer. By "isotropic herein is meant a polymer that is isotropic when tested by the TOT test or any reasonable variation thereof, as described in U.S. Patent 4,118,372. Mixtures of thermoplastic polymers and/or thermoplastic copolymers may be used. Examples of thermoplastic polymers include polyesters, polyamides, polyacetals, polycarbonates, polyphenylene oxides, polyphenylene sulfides, polysulphones, polyarylates, polyetheretherketones (PEEK), polyetherketoneketones (PEKK), and syndiotactic polystyrenes. Preferred are polyesters, polyamides, and polyacetals. More preferred are polyesters.

Preferred thermoplastic polyesters include polyesters having an inherent viscosity of 0.3 or greater and that are, in general, linear saturated condensation products of diols and dicarboxylic acids, or reactive derivatives thereof. Preferably, they will comprise condensation products of aromatic dicarboxylic acids having 8 to 14 carbon atoms and at least one diol selected from the group consisting of neopentyl glycol, cyclohexanedimethanol, 2,2-dimethyl-1,3-propane diol and aliphatic glycols of the formula HO(CH₂)ₙOH where n is an integer of 2 to 10. Up to 20 mole percent of the diol may be an aromatic diol such as ethoxylated bisphenol A, sold under the tradename Dianol 220 by Akzo Nobel Chemicals, Inc.; hydroquinone; biphenol; or bisphenol A. Up to 50 mole percent of the aromatic dicarboxylic acids can be replaced by at least one different aromatic dicarboxylic acid having from 8 to 14 carbon atoms, and/or up to 20 mole percent can be replaced by an aliphatic dicarboxylic acid having from 2 to 12 carbon atoms. Copolymers may be prepared from two or more diols or reactive equivalents thereof and at least one dicarboxylic acid or reactive equivalent thereof or two or more dicarboxylic acids or reactive equivalents thereof and at least one diol or reactive equivalent thereof. Difunctional hydroxy acid monomers such as hydroxybenzoic acid or hydroxynaphthoic acid or their reactive equivalents may also be used as comonomers.

Preferred polyesters include poly(ethylene terephthalate) (PET), poly(1,4-butylene terephthalate) (PBT), poly(propylene terephthalate) (PPT), poly(1,4-butylene naphthalate) (PBN), poly(ethylene naphthalate) (PEN), poly(1,4-cyclohexylene dimethylene terephthalate) (PCT), and copolymers and mixtures of the foregoing. Also preferred are 1,4-cyclohexylene dimethylene terephthalate/isophthalate copolymer and other linear homopolymer esters derived from aromatic dicarboxylic acids, including isophthalic acid; bibenzoic acid; naphthalenedicarboxylic acids including the 1,5-; 2,6-; and 2,7-naphthalenedicarboxylic acids; 4,4'-diphenylenedicarboxylic acid; bis(*p*-carboxyphenyl) methane; ethylene-bis-*p*-benzoic acid; 1,4-tetramethylene bis(*p*-oxybenzoic) acid; ethylene bis(*p*-oxybenzoic) acid; 1,3-trimethylene bis(*p-*oxybenzoic) acid; and 1,4-tetramethylene bis(*p*-oxybenzoic) acid, and glycols selected from the group consisting of 2,2-dimethyl-1,3-propane diol; neopentyl glycol; cyclohexane dimethanol; and aliphatic glycols of the general formula HO(CH₂)ₙOH where n is an integer from 2 to 10, e.g., ethylene glycol; 1,3-trimethylene glycol; 1,4-tetramethylene glycol;-1,6-hexamethylene glycol; 1,8-octamethylene glycol; 1,10-decamethylene glycol; 1,3-propylene glycol; and 1,4-butylene glycol. Up to 20 mole percent, as indicated above, of one or more aliphatic acids, including adipic, sebacic, azelaic, dodecanedioic acid or 1,4-cyclohexanedicarboxylic acid can be present. Also preferred are copolymers derived from 1,4-butanediol, ethoxylated bisphenol A, and terephthalic acid or reactive equivalents thereof. Also preferred are random copolymers of at least two of PET, PBT, and PPT, and mixtures of at least two-of PET, PBT, and PPT, and mixtures of any of the forgoing.

It is particularly preferred to use a poly(ethylene terephthalate) that has an inherent viscosity (IV) of at least about 0.5 at 30°C in a 3:1 volume ratio mixture of methylene chloride and trifluoroacetic acid. PET with a higher inherent viscosity in the range of 0.80 to 1.0 can be used in applications requiring enhanced mechanical properties such as increased tensile strength and elongation.

The thermoplastic polyester may also be in the form of copolymers that contain poly(alkylene oxide) soft segments. The poly(alkylene oxide) segments are to be present in 1 to 15 parts by weight per 100 parts per weight of thermoplastic polyester. The poly(alkylene oxide) segments have a number average molecular weight in the range of 200 to 3,250 or, preferably, in the range of 600 to 1,500. Preferred copolymers contain poly(ethylene oxide) incorporated into a PET or PBT chain. Methods of incorporation are known to those skilled in the art and can include using the poly(alkylene oxide) soft segment as a comonomer during the polymerization reaction to form the polyester. PET may be blended with copolymers of PBT and at least one poly(alkylene oxide). A poly(alkyene oxide) may also be blended with a PET/PBT copolymer. The inclusion of a poly(alkylene oxide) soft segment into the polyester portion of the composition may accelerate the rate of crystallization of the polyester.

Preferred polyamides include polyamide 6, polyamide 66, polyamide 612, polyamide 610, or other aliphatic polyamides and semi-aromatic polyamides, such as those derived from terephthalic acid and/or isophthalic acid. Examples include polyamides 9T; 10T; 12T; polyamides derived from hexamethylenediamine, adipic acid, and terephthalic acid; and polyamides derived from hexamethylenediamine, 2-methylpentamethylenediamine, and terephthalic acid. Blends of two or more polyamides may be used.

Polyacetals can be either one or more homopolymers, copolymers, or a mixture thereon. Homopolymers are prepared by polymerizing formaldehyde or formaldehyde equivalents, such as cyclic oligomers of formaldehyde. Copolymers can contain one or more comonomers generally used in preparing polyoxymethylene compositions. Commonly used comonomers include alkylene oxides of 2-12 carbon atoms. If a copolymer is selected, the quantity of comonomer will not be more than 20 weight percent, preferably not more than 15 weight percent, and most preferably about two weight percent. Preferable comonomers are ethylene oxide and butylene oxide, and preferable polyoxymethylene copolymers are copolymers of formaldehyde and ethylene oxide or butylene oxide where the quantity of ethylene oxide or butylene oxide is about two (2) weight percent. It is also preferred that the homo-and copolymers are: 1) those whose terminal hydroxy groups are end-capped by a chemical reaction to form ester or ether groups; or, 2) copolymers that are not completely end-capped, but that have some free hydroxy ends from the comonomer unit. Preferred end groups, in either case, are acetate and methoxy.

The thermoplastic polymer will preferably be present in 15 to 70 weight percent, or more preferably 30 to 60 weight percent, based on the total weight of the composition.

The calcium fluoride used as component (b) in the present invention will preferably be in the form of a powder. The calcium fluoride will preferably not been surface coated or treated prior to use. Surface coated or treated calcium fluoride may be used if a polymeric toughening agent together with a liquid crystalline polymer is used in the composition. Examples of surface coatings are aminosilanes or expoxysilanes.

The calcium fluoride will preferably be present in 30 to 70 weight percent, or more preferably in 45 to 60 weight percent, based on the total weight of the composition.

The fibrous filler used as component (c) in the present invention is a needle-like fibrous material. Examples of preferred fibrous fillers include wollastonite (calcium silicate whiskers), glass fibers, aluminum borate fibers, calcium carbonate fibers, and potassium titanate fibers. The fibrous filler will preferably have a weight average aspect ratio of at least 5, or more preferably of at least 10. When used, the optional fibrous filler will preferably be present in about 5 to about 30 weight percent, or more preferably in about 5 to about 20 weight percent, based on the total weight of the composition.

By a "liquid crystalline polymer" (abbreviated "LCP") is meant a polymer that is anisotropic when tested using the TOT test or any reasonable variation thereof, as described in U.S. Patent 4,118,372. Useful LCP's include polyesters, poly(ester-amides), and poly(ester-imides). One preferred form of LCP is "all aromatic", that is all of the groups in the polymer main chain are aromatic (except for the linking groups such as ester groups), but side groups which are not aromatic may be present. The liquid crystalline polymers of component (d) of the compositions of the present invention, will be present in 5 to 40 weight percent, or preferably in 10 to 30 weight percent, based on the total weight of the composition.

The polymeric toughening agent optionally used as component (e) in the present invention is any toughening agent that is effective for the thermoplastic polymer used.

When the thermoplastic polymer is a polyester, the toughening agent will typically be an elastomer or has a relatively low melting point, generally <200 °C, preferably <150 °C and that has attached to it functional groups that can react with the thermoplastic polyester (and optionally other polymers present). Since thermoplastic polyesters usually have carboxyl and hydroxyl groups present, these functional groups usually can react with carboxyl and/or hydroxyl groups. Examples of such functional groups include epoxy, carboxylic anhydride, hydroxyl (alcohol), carboxyl, and isocyanate. Preferred functional groups are epoxy, and carboxylic anhydride, and epoxy is especially preferred. Such functional groups are usually "attached" to the polymeric toughening agent by grafting small molecules onto an already existing polymer or by copolymerizing a monomer containing the desired functional group when the polymeric tougher molecules are made by copolymerization. As an example of grafting, maleic anhydride may be grafted onto a hydrocarbon rubber using free radical grafting techniques. The resulting grafted polymer has carboxylic anhydride and/or carboxyl groups attached to it. An example of a polymeric toughening agent wherein the functional groups are copolymerized into the polymer is a copolymer of ethylene and a (meth)acrylate monomer containing the appropriate functional group. By (meth)acrylate herein is meant the compound may be either an acrylate, a methacrylate, or a mixture of the two. Useful (meth)acrylate functional compounds include (meth)acrylic acid, 2-hydroxyethyl (meth)acrylate, glycidyl (meth)acrylate, and 2-isocyanatoethyl (meth)acrylate. In addition to ethylene and a functional (meth)acrylate monomer, other monomers may be copolymerized into such a polymer, such as vinyl acetate, unfunctionalized (meth)acrylate esters such as ethyl (meth)acrylate, n-butyl (meth)acrylate, and cyclohexyl (meth)acrylate. Preferred toughening agents include those listed in U.S. Patent 4,753.980. Especially preferred toughening agents are copolymers of ethylene, ethyl acrylate or n-butyl acrylate, and glycidyl methacrylate.

It is preferred that the polymeric toughening agent used with thermoplastic polyesters contain 0.5 to 20 weight percent of monomers containing functional groups, preferably 1.0 to 15 weight percent, more preferably 7 to 13 weight percent of monomers containing functional groups. There may be more than one type of functional monomer present in the polymeric toughening agent. It has been found that toughness of the composition is increased by increasing the amount of polymeric toughening agent and/or the amount of functional groups. However, these amounts should preferably not be increased to the point that the composition may crosslink, especially before the final part shape is attained.

The polymeric toughening agent used with thermoplastic polyesters may also be thermoplastic acrylic polymers that are not copolymers of ethylene. The thermoplastic acrylic polymers are made by polymerizing acrylic acid, acrylate esters (such as methyl acrylate, n-propyl acrylate, isopropyl acrylate, n-butyl acrylate, n-hexyl acrylate, and n-octyl acrylate), methacrylic acid, and methacrylate esters (such as methyl methacrylate, n-propyl methacrylate, isopropyl methacrylate, n-butyl methacrylate (BA), isobutyl methacrylate, n-amyl methacrylate, n-octyl methacrylate, glycidyl methacrylate (GMA) and the like). Copolymers derived from two or more of the forgoing types of monomers may also be used, as well as copolymers made by polymerizing one or more of the forgoing types of monomers with styrene, acryonitrile, butadiene, and isoprene. Part or all of the components in these copolymers should preferably have a glass transition temperature of not higher than 0°C. Preferred monomers for the preparation of a thermoplastic acrylic polymer toughening agent are methyl acrylate, n-propyl acrylate, isopropyl acrylate, n-butyl acrylate, n-hexyl acrylate, and n-octyl acrylate.

It is preferred that a thermoplastic acrylic polymer toughening agent have a core-shell structure. The core-shell structure is one in which the core portion preferably has a glass transition temperature of 0 °C or less, while the shell portion is preferably has a glass transition temperature higher than that of the core portion. The core portion may be grafted with silicone. The shell section may be grafted with a low surface energy substrate such as Silicone, and fluorine. An acrylic polymer with a core-shell structure that has low surface energy substrates grafted to the surface will aggregate with itself during or after mixing with the thermoplastic polyester and other components of the composition of the invention and can be easily uniformly dispersed in the composition.

Suitable toughening agents for polyamides are described in US Patent 4,174,358. Preferred toughening agents include polyolefins modified with a compatibilizing agent such as an acid anhydride, dicarboxylic acid or derivative thereof, carboxylic acid or derivative thereof, and/or an epoxy group. The compatibilizing agent may be introduced by grafting an unsaturated acid anhydride, dicarboxylic acid or derivative thereof, carboxylic acid or derivative thereof, and/or an epoxy group to a polyolefin. The compatibilizing agent may also be introduced while the polyolefin is being made by copolymerizing with monomers containing an unsaturated acid anhydride, dicarboxylic acid or derivative thereof, carboxylic acid or derivative thereof, and/or an epoxy group. The compatibilizing agent preferably contains from 3 to 20 carbon atoms. Examples of typical compounds that may be grafted to (or used as comonomers to make) a polyolefin are acrylic acid, methacrylic acid, maleic acid, fumaric acid, itaconic acid, crotonic acid, citrconic acid, maleic anhydride, itaconic anhydride, crotonic anhydride and citraconic anhydride.

Preferred toughening agents for polyacetals include thermoplastic polyurethanes, polyester polyether elastomers, other functionalized and/or grafted rubber, and polyolefins that contain polar groups that are either grafted to their backbones or were incorporated by copolymerizing with a monomer that contained one or more polar groups. Preferable comonomers are those that contain epoxide groups, such as glycidyl methacrylate. A preferred toughening agent is EBAGMA (a terpolymer derived from ethylene, butyl acrylate, and glycidyl methacrylate).

When used, the optional polymeric toughening agent will preferably be present in 2 to 15 weight percent, or more preferably in 5 to 15 weight percent, based on the total weight of the composition.

The compositions of this invention may optionally include one or more plasticizers that are suitable for the thermoplastic polymer used. Examples of suitable plasticizers for thermoplastic polyesters are include poly(ethylene glycol) 400 bis(2-ethyl hexanoate), methoxypoly(ethylene glycol) 550 (2-ethyl hexanoate), and tetra(ethylene glycol) bis(2-ethyl hexanoate). When used, the plasticizer will preferably be present in 0.5 to 5 weight percent, based on the total weight of the composition.

When the thermoplastic polymer used in the composition of this invention is a polyester, the composition may also optionally include one or more nucleating agents such as a sodium or potassium salt of a carboxylated organic polymer, the sodium salt of a long chain fatty acid, and sodium benzoate. Part or all of the polyester may be replaced with a polyester having end groups, at least some of which have been neutralized with sodium or potassium. When used, the nucleating agent will preferably be present in 0.1 to 4 weight percent, based on the total weight of the composition.

The composition of the present invention may also optionally include one or more flame retardants. Examples of suitable flame retardants include, but are not limited to brominated polystyrene, polymers of brominated styrenes, brominated epoxy compounds, brominated polycarbonates, and poly(pentabromobenzyl acrylate). When used, the flame retardant will preferably be present in 5 to 20 weight percent, based on the total weight of the composition. Compositions comprising flame retardants may further comprise one or more flame retardant synergists such as, but not limited to, sodium antimonate and antimony oxide. When used, the nucleating agent will preferably be present in 1 to 6 weight percent, based on the total weight of the composition.

The thermoplastic resin composition of this invention may also optionally include, in addition to the above components, additives such as heat stabilizers, antioxidants, dyes, pigments, mold release agents, lubricants, UV stabilizers, and (paint) adhesion promoters. When used, the foregoing additives will in combination preferably be present in 0.1 to 5 weight percent, based on the total weight of the composition.

The compositions of the present invention are in the form of a melt-mixed blend, wherein all of the polymeric components are well-dispersed within each other and all of the non-polymeric ingredients are homogeneously dispersed in and bound by the polymer matrix, such that the blend forms a unified whole. The blend may be obtained by combining the component materials using any melt-mixing method. The component materials may be mixed to homogeneity using a melt-mixer such as a single or twin-screw extruder, blender, kneader, or Banbury mixer to give a resin composition. Part of the materials may be mixed in a melt-mixer, and the rest of the materials may then be added and further melt-mixed until homogeneous. The sequence of mixing in the manufacture of the thermally conductive polymer resin composition of this invention may be such that individual components may be melted in one shot, or the filler and/or other components may be fed from e.g. a side feeder , as will be understood by those skilled in the art.

The composition of the present invention may be formed into articles using methods known to those skilled in the art, such as, for example, injection molding, blow molding, or extrusion. Such articles can include those for use in motor housings, lamp housings, lamp housings in automobiles and other vehicles, and electrical and electronic housings. Examples of lamp housings in automobiles and other vehicles are front and rear lights, including headlights, tail lights, and brake lights, particularly those that use light-emitting diode (LED) lamps. The articles may serve as replacements for articles made from aluminum or other mentals in many applications.

### Examples

### Compounding and Molding Method

The polymeric compositions shown in Table 1 were prepared by compounding in a 30 mm Werner and Pfleiderer twin screw extruder. All ingredients were blended together and added to the rear (barrel 1) of the extruder except that Nyglos and glass fibers were side-fed into barrel 5 (of 10 barrels) and the plasticizer was added using a liquid injection pump. Barrel temperatures were set at about 270 °C for poly(butylene terephthalate) compositions and about 285 °C poly(ethylene terephthalate) compositions resulting in melt temperatures of about 280 and 320 °C, respectively.

The compositions were molded into ASTM test specimens on a 88.7 or 177.4 ml (3 or6 oz) injection molding machine for the measurement of mechanical properties. For thermal conductivity testing they were molded into 5.08cm (2 inch) diameter disks with a thickness of 3,2 mm (1/8 inch). Melt temperature were about 270-300 °C and mold temperatures were about 80 ° for poly(butylene terephthalate) compositions and 120 °C for poly(ethylene terephthalate) compositions.

### Testing methods

Thermal conductivity was determined or 5.08cm (2 inch) diameter disks with a thickness of 3.2mm (1/8 inch) using a Holometrix TCA-300 thermal conductivity analyzer at 50 °C, following ASTM F-433-77. Results are shown in Table 1. A thermal conductivity of at least 0.5 W/m•K is deemed to be acceptable.

Tensile strength was determined using ASTM D638-58T.

Flexural modulus was determined using ASTM D790-58T.

Notched Izod impact resistance was determined using ASTM D256.

Melt viscosity was determined using a Kayeness melt rheometer at 1000 cm⁻¹ and the temperatures shown in Table 1.

The following terms are used in Table 1:
PBT refers to Crastin® 6131, a poly(butylene terephthalate) homopolymer with an inherent viscosity of about 0.82 manufactured by E.I. du Pont de Nemours and Co., Wilmington, DE.
PET refers to Crystar® TF3934, a poly(ethylene terephthalate) homopolymer with an inherent viscosity of about 0.67 manufactured by E.I. du Pont de Nemours and Co., Wilmington, DE.
Calcium fluoride is 325 mesh powder manufactured by Seaforth Mineral & Ore Co.,Inc., Cleveland, OH.
Barium sulfate is Gradde Blanc-fixe HD80 manufactured by Sachtleben Chemie GmbH Duisburg, Germany.
Mica is Phlogopite Mica 5040 manufactured by Seaforth Mineral & Ore Co.,Inc Cleveland, OH.
Nyglos® 4 refers to wollastonite fibers with an average length of approximately 9 µm and no sizing available from Nyco Minerals, Calgary, Alberta, Canada.
EBAGMA refers to an ethylene/*n*-butyl acrylate/glycidyl methacrylate terpolymer made from 66.75 weight percent ethylene, 28 weight percent *n*-butyl acrylate, and 5.25 weight percent glycidyl methacrylate. It has a melt index of 12 g/10 minutes as measured by ASTM method D1238.
Plasthall® 809 refers to poly(ethylene glycol) 400 di-2-ethylhexanoate, a plasticizer supplied by the C.P. Hall Company, Chicago, III.
Glass fibers refers to PPG 3563 glass fibers manufactured by PPG Industries, Inc. Pittsburgh, PA..
Irganox® 1010 refers to an antioxidant manufactured by Ciba Specialty Chemicals, Inc., Tarrytown, NY.
LCP refers to Zenite® 6000, a liquid crystalline polymer manufactured by E.I. du Pont de Nemours and Co., Wilmington, DE.

**Table 1**

| | Comp Ex. 1 | Comp. Ex. 2 | Comp. Ex. 3 | Comp. Ex. 4 | Comp. Ex 5 | Comp. Ex. 6 | Comp Ex. 7 | Comp. Ex. 8 | Ex. 1 |
|---|---|---|---|---|---|---|---|---|---|
| PBT | 45 | 45 | 45 | 25 | 22 | 25 | -- | -- | -- |
| PET | -- | -- | -- | -- | -- | -- | 99.8 | 59.8 | 24.8 |
| Calcium fluoride | -- | -- | 40 | 50 | 50 | 50 | -- | -- | 40 |
| Barium sulfate | -- | 40 | -- | -- | -- | -- | -- | -- | -- |
| Mica | 40 | -- | -- | -- | -- | -- | -- | -- | -- |
| Nyglos® 4 | 15 | 15 | 15 | 15 | 15 | -- | -- | -- | 15 |
| EBAGMA (5% GMA) | -- | -- | -- | 10 | 10 | 10 | -- | -- | -- |
| Plasthall® 809 | -- | -- | -- | -- | 3 | -- | -- | -- | -- |
| Glass fibers | -- | -- | -- | -- | -- | 15 | -- | -- | -- |
| Irganox® 1010 | -- | -- | -- | -- | -- | -- | 0.2 | 0.2 | 0.2 |
| LCP | -- | -- | -- | -- | -- | -- | -- | 40 | 20 |
| | | | | | | | | | |
| Thermal conductivity (W/m•K) | 0.41 | 0.42 | 0.65 | 0.72 | 0.70 | 0.68 | 0.27 | 0.34 | 0.79 |
| Tensile strength (kg/cm²) | -- | -- | -- | 285 | 169 | 630 | 590 | 418 | 481 |
| Flexural modulus (kg/cm²) | -- | -- | -- | 44990 | 22698 | 70854 | 23458 | 26931 | 87439 |
| Notched Izod (kg•cm/cm) | -- | -- | -- | 7.2 | 8.0 | 12.6 | 2.8 | 1.3 | 1.8 |
| Melt viscosity (250°C at 1000 cm⁻¹) (Pa•s) | -- | -- | -- | 464 | 242 | 619 | -- | -- | -- |
| Melt viscosity (280°C at 1000 cm⁻¹)(Pa•s) | -- | -- | -- | -- | -- | -- | 137 | 292 | 519 |

All ingredient quantities are given in weight percent relative to the total weight of the composition.

A comparison of comparative Example 3 with Comparative Examples 1 and 2 demonstrates that thermoplastic polymer compositions containing calcium fluoride show acceptable thermal conductivity, while those containing other fillers (barium sulfate and mica) do not. Comparative Examples 4-6 demonstrate that thermoplastic polymer compositions containing calcium fluoride and having good thermal conductivity can be toughened by using a polymeric impact modifier. Comparative Example 5 demonstrates that the melt viscosity of such compositions may be decreased by using a plasticizer. A comparison of Example 1 with Comparative Examples 7 and 8 demonstrates that compositions having good thermal conductivity can be obtained using liquid crystalline polymers and calcium fluoride. And comparison of Example 1 with

Comparative Example 3 shows that the use of liquid crystalline polymers in thermoplastic polymer compositions containing calcium fluoride can further increase thermal conductivity.

## Claims

1. A thermally conductive thermoplastic polymer composition, comprising:
(a) 15 to 70 weight percent of at least one isotropic thermoplastic polymer selected from the group consisting of thermoplastic polyesters, polyamides, polyacetals, polycarbonates, polyphenylene oxides, polyphenylene sulfides, polysulphones, polyarylates, polyetheretherketones, polyetherketoneketones, and syndiotactic polystyrenes;
(b) 30 to 70 weight percent of uncoated, surface coated or treated calcium fluoride;
(c) 0 to 30 weight percent of at least one fibrous filler;
(d) 5 to 40 weight percent of at least one liquid crystalline polymer and;
(e) 0 to 15 weight percent of at least one polymeric toughening agent, the above stated percentages being based on the total weight of the composition.

2. The composition of claim 1 wherein the fibrous filler is present in from 5 to 30 weight percent, based on the total weight of the composition.

3. The composition of claim 1 wherein the thermoplastic polymer is at least one thermoplastic polyester.

4. The composition of claim 1 wherein the polymeric toughening agent is present in 2 to 15 weight percent, based on the total weight of the composition.

5. The composition of claim 1 wherein the fibrous filler is wollastonite.

6. The composition of claim 3 wherein the polymeric toughening agent is present and is a copolymer of ethylene, butyl acrylate, and glycidyl methacrylate and/or a copolymer of ethylene, ethyl acrylate, and glycidyl methacrylate.

7. The composition of claim 6 wherein the polymeric toughening agent is a core-shell acrylic polymer.

8. The composition of claim 1 wherein said calcium fluoride is surface-coated calcium fluoride.

9. An article made from the composition of claim 1.

10. The article of claim 9 in the form of a motor housing.

11. The article of claim 9 in the form of an automotive lamp housing.

12. An article made from the composition of claim 8.

## Patentansprüche

1. Thermisch leitfähige thermoplastische Polymerzusammensetzung umfassend:
(a) 15 bis 70 Gewichtsprozent mindestens eines isotropen thermoplastischen Polymers ausgewählt aus der Gruppe bestehend aus thermoplastischen Polyestern, Polyamiden, Polyacetalen, Polycarbonaten, Polyphenylenoxiden, Polyphenylensulfiden, Polysulfonen, Polyarylaten, Polyetheretherketonen, Polyetherketonketonen und syndiotaktischen Polystyrolen;
(b) 30 bis 70 Gewichtsprozent unbeschichtetes, oberflächenbeschichtetes oder -behandeltes Calciumfluorid;
(c) 0 bis 30 Gewichtsprozent mindestens eines faserigen Füllstoffs;
(d) 5 bis 40 Gewichtsprozent mindestens eines flüssigen kristallinen Polymers; und
(e) 0 bis 15 Gewichtsprozent mindestens eines polymeren schlagfest machenden Mittels,
wobei die oben angegebenen Prozentsätze auf das Gesamtgewicht der Zusammensetzung bezogen sind.

2. Zusammensetzung nach Anspruch 1, wobei der faserige Füllstoff in einer Menge von 5 bis 30 Gewichtsprozent, auf das Gesamtgewicht der Zusammensetzung bezogen, vorliegt.

3. Zusammensetzung nach Anspruch 1, wobei das thermoplastische Polymer mindestens einem thermoplastischen Polyester ist.

4. Zusammensetzung nach Anspruch 1, wobei das polymere schlagfest machende Mittel in einer Menge von 2 bis 15 Gewichtsprozent, auf das Gesamtgewicht der Zusammensetzung bezogen, vorliegt.

5. Zusammensetzung nach Anspruch 1, wobei der faserige Füllstoff Wollastonit ist.

6. Zusammensetzung nach Anspruch 3, wobei das polymere schlagfest machende Mittel vorliegt und ein Copolymer von Ethylen, Butylacrylat und Glycidylmethacrylat und/oder ein Copolymer von Ethylen, Ethylacrylat und Glycidylmethacrylat ist.

7. Zusammensetzung nach Anspruch 6, wobei das polymere schlagfest machende Mittel ein Kern-Mantel-Acrylpolymer ist.

8. Zusammensetzung nach Anspruch 1, wobei das Calciumfluorid oberflächenbeschichtetes Calciumfluorid ist.

9. Gegenstand, der aus der Zusammensetzung nach Anspruch 1 hergestellt ist.

10. Gegenstand nach Anspruch 9, in Form eines Motorengehäuses.

11. Gegenstand nach Anspruch 9, in Form eines Fahrzeuglampengehäuses.

12. Gegenstand, der aus der Zusammensetzung nach Anspruch 8 hergestellt ist.

## Revendications

1. Composition polymère thermoplastique thermiquement conductrice, comprenant:
(a) 15 à 70 pour cent en poids d'au moins un polymère thermoplastique isotrope choisi parmi le groupe constitué des polyesters thermoplastiques, polyamides, polyacétals, polycarbonates, oxydes de polyphénylène, sulfures de polyphénylène, polysulfones, polyarylates, polyétheréthercétones, polyéthercétonecétones, et des polystyrènes syndiotactiques;
(b) 30 à 70 pour cent en poids de fluorure de calcium non revêtu ou revêtu ou traité en surface;
(c) 0 à 30 pour cent en poids d'au moins une charge fibreuse;
(d) 5 à 40 pour cent en poids d'au moins un polymère cristallin liquide; et
(e) 0 à 15 pour cent en poids d'au moins un agent de durcissement polymère,
les pourcentages ci-dessus énoncés étant basés sur le poids total de la composition.

2. Composition selon la revendication 1, la charge fibreuse étant présente en une quantité de 5 à 30 pour cent en poids, basée sur le poids total de la composition.

3. Composition selon la revendication 1, le polymère thermoplastique étant au moins un polyester thermoplastique.

4. Composition selon la revendication 1, l'agent de durcissement polymère étant présent en une quantité de 2 à 15 pour cent en poids, basée sur le poids total de la composition.

5. Composition selon la revendication 1, la charge fibreuse étant de la wollastonite.

6. Composition selon la revendication 3, l'agent de durcissement polymère étant présent et étant un copolymère d'éthylène, acrylate de butyle, et méthacrylate de glycidyle et/ou un copolymère d'éthylène, d'acrylate d'éthyle, et de méthacrylate de glycidyle.

7. Composition selon la revendication 6, l'agent de durcissement polymère étant un polymère acrylique de type âme-enveloppe.

8. Composition selon la revendication 1, ledit fluorure de calcium étant du fluorure de calcium revêtu en surface.

9. Article produit à partir de la composition selon la revendication 1.

10. Article selon la revendication 9, sous la forme d'un carter de moteur.

11. Article selon la revendication 9, sous la forme d'un logement de phare d'automobile.

12. Article produit à partir de la composition selon la revendication 8.
